# DEMANDE DE BREVET EUROPEEN

(11) **EP 4 332 186 A1**
(43) Date de publication de la demande: **06.03.2024**
(21) Numéro de dépôt: 23194100.6
(22) Date de dépôt: 29.08.2023
(51) Int. Cl.: C09J 5/06, H01L 21/683

(54) **PROCEDE DE TRANSFERT D'UNE COUCHE ADHESIVE EN POLYMERE(S) THERMOPLASTIQUE(S) D'UN PREMIER SUBSTRAT VERS UN DEUXIEME SUBSTRAT**

(30) Priorité: 30.08.2022 FR 2208678
(71) Demandeur: Commissariat à l'énergie atomique et aux énergies alternatives, 75015 Paris (FR)
(72) Inventeur: MONTMEAT, Pierre, 38054 GRENOBLE CEDEX 09 (FR); FOURNEL, Frank, 38054 GRENOBLE CEDEX 09 (FR); ENYEDI, Grégory, 38054 GRENOBLE CEDEX 09 (FR); VAUDAINE, Simon, 38054 GRENOBLE CEDEX 09 (FR)
(74) Mandataire: Brevalex

(57) **Abrégé**

L'invention a trait à un procédé de transfert d'une couche adhésive en polymère(s) thermoplastique(s) d'un premier substrat vers un deuxième substrat comprenant les étapes suivantes :
-une étape de dépôt sur un premier substrat d'une couche antiadhésive, cette couche étant déposée sur la périphérie de la face supérieure dudit substrat, dite couche périphérique, ménageant ainsi sur ladite face supérieure une zone dépourvue de ladite couche, dite zone centrale ;
-une étape de dépôt sur ladite zone centrale d'une couche adhésive en polymère(s) thermoplastique(s) ;
-une étape de dépôt sur un deuxième substrat d'une couche antiadhésive, cette couche étant déposée sur la face supérieure du deuxième substrat à l'exclusion de sa périphérie, ladite périphérie étant ainsi dépourvue de ladite couche antiadhésive ;
-une étape de collage du premier substrat et du deuxième substrat consistant à thermocomprimer la face supérieure du premier substrat sur la face supérieure du deuxième substrat ;
-une étape de retrait du premier substrat, moyennant quoi il subsiste le deuxième substrat dont la face supérieure est recouverte par la couche adhésive en polymère(s) thermoplastique(s).

## Description

### DOMAINE TECHNIQUE

L'invention se rapporte à un procédé de transfert d'une couche adhésive en polymère(s) thermoplastique(s) d'un premier substrat vers un deuxième substrat, ce deuxième substrat pouvant être ensuite utilisé dans les techniques de collage temporaire par exemple, pour la conception de composants électroniques.

Plus spécifiquement, les techniques de collage temporaire trouvent une application dans la fabrication de composants électroniques, tels que des circuits intégrés, sur deux faces d'une plaque, par exemple, en silicium, une telle fabrication nécessitant la mise en place sur une des faces de la plaque d'un substrat temporaire (ou poignée temporaire) pour pouvoir manipuler ladite plaque et intégrer des composés électroniques sur l'autre face non occupée par le substrat temporaire. Ce substrat temporaire destiné comme son nom l'indique à être supprimé de la face qu'il occupe est donc soumis à un collage temporaire sur la face concernée.

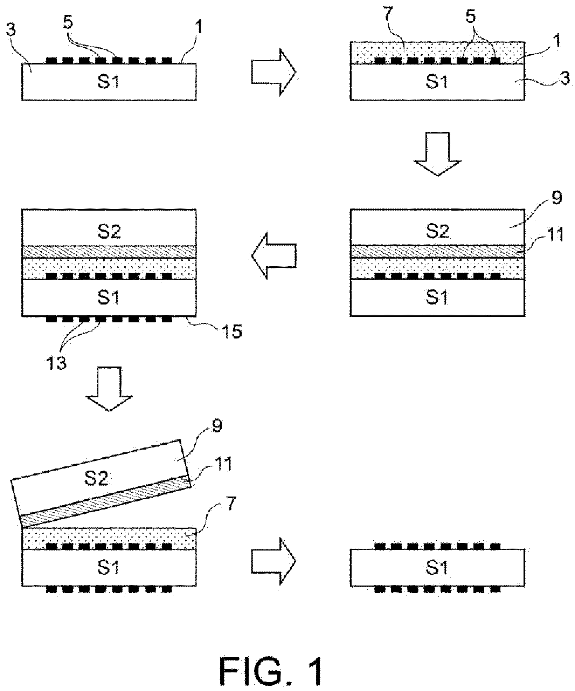

Classiquement, la fabrication de composants électroniques sur deux faces d'une plaque (dénommé ci-après, substrat d'intérêt) impliquant un collage temporaire comprend les étapes suivantes illustrées sur la figure 1 jointe en annexe :
- une étape de dépôt sur la face supérieure 1 d'un substrat d'intérêt 3, dit S1, (par exemple, une plaque de silicium) déjà pourvue de composants électroniques 5 d'une couche adhésive 7 (par exemple, une couche en polymère(s) thermoplastique(s) adhésif(s)) ;
- une étape de collage, sur ladite face supérieure du substrat d'intérêt, d'un substrat temporaire 9, dit S2 (ou poignée temporaire), par exemple, par thermocompression, lequel substrat permet, d'une part, d'occulter et protéger la face supérieure et servant, d'autre part, de prise pour pouvoir manipuler le substrat d'intérêt sans dégradation de cette face supérieure, le substrat temporaire comportant, sur sa face destinée à être en contact avec la face supérieure du substrat d'intérêt, une couche de démontage antiadhésive 11 ;
- une étape de réalisation de composants électroniques 13 sur la face inférieure libre 15 (opposée à la face supérieure) du substrat d'intérêt ;
- une étape de retrait du substrat temporaire 9 de la face supérieure du substrat d'intérêt, cette étape de retrait étant facilitée par la nature de la couche de démontage, qui assure une faible adhérence entre la couche adhésive et le substrat temporaire ;
- une étape d'élimination de la couche adhésive 7 de la face supérieure, moyennant quoi il subsiste un substrat d'intérêt muni de composants électroniques tant sur sa face supérieure que sur sa face inférieure.

La couche adhésive se compose classiquement d'un ou plusieurs polymères thermoplastiques à caractère adhésif fournis, par exemple, *via* une formulation liquide comprenant le ou lesdits polymères thermoplastiques et au moins un solvant organique. Dans ce cas, la couche adhésive est formée par dépôt, par exemple, par enduction centrifuge, de la formulation liquide sur la face supérieure du substrat d'intérêt puis par traitement thermique de la couche déposée pour en éliminer le ou les solvants organiques.

Il peut être difficile voire impossible de procéder au dépôt d'une couche adhésive sur un substrat d'intérêt et ce pour les raisons suivantes :
- les composants électroniques présents sur la face supérieure du substrat d'intérêt ou le substrat d'intérêt en tant que tel ne supportent pas le traitement thermique nécessaire pour la formation de la couche adhésive ;
- la face supérieure du substrat d'intérêt présente une mouillabilité insuffisante pour assurer le dépôt homogène et couvrant de la formulation liquide ;
- le substrat d'intérêt présente une incompatibilité avec le dispositif de dépôt de la formulation liquide (par exemple, en termes d'épaisseur, de type de matériau, de contamination métallique) ;
- la topographie du substrat d'intérêt n'est pas adaptée au procédé de dépôt de la formulation liquide et aux étapes subséquentes au dépôt.

Pour pallier ces limitations et inconvénients, il conviendrait de pouvoir introduire la couche adhésive autrement que par dépôt sur le substrat d'intérêt, par exemple, par apport de cette couche au substrat temporaire.

Aussi, fort de ce constat, les inventeurs ont mis au point une solution permettant d'apporter une couche adhésive au substrat temporaire, cette solution s'inscrivant plus généralement dans un procédé de transfert d'une couche adhésive en polymère(s) thermoplastique(s) d'un substrat vers un autre.

### EXPOSÉ DE L'INVENTION

Ainsi, l'invention a trait à un procédé de transfert d'une couche adhésive en polymère(s) thermoplastique(s) d'un premier substrat vers un deuxième substrat comprenant les étapes suivantes :
- une étape de dépôt sur un premier substrat d'une couche antiadhésive, cette couche étant déposée sur la périphérie de la face supérieure dudit substrat, dite couche périphérique, ménageant ainsi sur ladite face supérieure une zone dépourvue de ladite couche, dite zone centrale ;
- une étape de dépôt sur ladite zone centrale d'une couche adhésive en polymère(s) thermoplastique(s) ;
- une étape de dépôt sur un deuxième substrat d'une couche antiadhésive, cette couche étant déposée sur la face supérieure du deuxième substrat à l'exclusion de sa périphérie, ladite périphérie étant ainsi dépourvue de ladite couche antiadhésive ;
- une étape de collage du premier substrat et du deuxième substrat consistant à thermocomprimer la face supérieure du premier substrat sur la face supérieure du deuxième substrat ;
- une étape de retrait du premier substrat, moyennant quoi il subsiste le deuxième substrat dont la face supérieure est recouverte par la couche adhésive en polymère(s) thermoplastique(s).

Le procédé permet ainsi un transfert efficace d'une couche adhésive en polymère(s) thermoplastique(s) d'un premier substrat vers un deuxième substrat et par ailleurs, la couche adhésive en polymère(s) thermoplastique(s) pourra ultérieurement être facilement décollée, du fait qu'elle n'adhère sur le deuxième substrat que sur la périphérie de sa face supérieure, le reste de la face supérieure étant occupée par une couche antiadhésive. Aussi, la couche adhésive pourra ainsi facilement être rapportée ultérieurement sur un autre substrat.

Comme mentionné ci-dessus, le procédé de l'invention comprend, en premier lieu, une étape de dépôt sur un premier substrat d'une couche antiadhésive, cette couche étant déposée à la périphérie de la face supérieure dudit substrat, dite couche périphérique, ménageant ainsi sur ladite face supérieure une zone dépourvue de ladite couche, dite zone centrale. Autrement dit, à l'issue de cette étape de dépôt, la face supérieure du premier substrat est revêtue d'une couche périphérique antiadhésive, sa zone centrale restant ainsi dépourvue de ladite couche.

On précise que, par face supérieure, il s'entend la face qui sert de base de dépôt sur le premier substrat et sur le deuxième substrat en opposition à la face dite inférieure opposée à ladite face supérieure, qui ne fait l'objet d'aucun dépôt dans le cadre de ce procédé.

Le premier substrat et/ou le deuxième substrat peu(ven)t être en un matériau semi-conducteur, par exemple, du silicium, du germanium ou un alliage silicium-germanium et, plus spécifiquement, peu(ven)t être un substrat en silicium.

La couche périphérique antiadhésive du premier substrat présente, comme son nom l'indique, des propriétés antiadhésives et, avantageusement, une énergie de surface inférieure à 20 mJ/m². L'énergie de surface d'un solide peut être mesurée au moyen de la méthode d'Owens/Wendt décrite dans la référence suivante : D.K. Owens; R.C. Wendt, Estimation of the Surface Free Energy of Polymers, in : Journal of Applied Polymer Science Vol. 13, pp. 1741-1747 (1969).

Lorsque le premier substrat est une plaque circulaire en silicium, la couche périphérique antiadhésive se présente, avantageusement, sous forme d'une couronne qui peut présenter une largeur supérieure ou égale à 1 mm.

Plus spécifiquement, la couche périphérique antiadhésive peut être, en particulier :
- une couche en un ou plusieurs polymères halogénés, tels qu'un polymère issu de la polymérisation d'au moins un monomère fluoré, par exemple, un monomère acrylate fluoré, un monomère éthylénique fluoré ;
- une couche en un ou plusieurs composés silanes greffés sur le premier substrat et, plus particulièrement, une couche issue de la réaction d'un ou plusieurs composés halogénosilanes avec le premier substrat (notamment, lorsque celui-ci est un substrat en silicium), les composés halogénosilanes utilisables étant, par exemple, l'octadécyltrichlorosilane ou le perfluorodécyltrichlorosilane.

L'étape de dépôt de la couche périphérique antiadhésive peut comprendre, en particulier, les opérations suivantes :
- une opération de mise en contact du premier substrat, au niveau de la périphérie de sa face supérieure, avec une composition liquide comprenant un ou plusieurs composés antiadhésifs et au moins un solvant organique, la mise en contact pouvant se faire, par exemple, par enduction centrifuge ;
- une opération de séchage de ladite composition ainsi déposée par évaporation du ou desdites solvants.

Lors du séchage, si la composition comprend un ou plusieurs composés halogénosilanes et que le premier substrat est un substrat en silicium, le ou les composés halogénosilanes vont réagir avec les groupes hydroxyles présents spontanément à la surface du substrat en silicium pour former des greffons apportant le caractère antiadhésif à la périphérie du premier substrat.

Ainsi, à titre d'exemple, lorsque le premier substrat est un substrat en silicium et que le composé halogénosilane utilisé est du perfluorodécyltrichlorosilane, la couche périphérique antiadhésive correspond ainsi à une couche comprenant des greffons issus de la réaction du perfluorodécyltrichlorosilane avec le substrat en silicium, lesdits greffons répondant à la formule suivante : 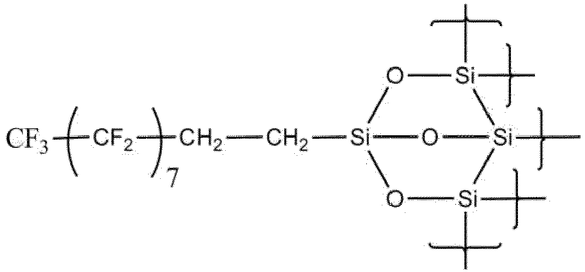 les accolades positionnées au niveau des atomes de silicium appartenant au substrat en silicium, les atomes d'oxygène étant issus des groupes hydroxyles présents spontanément à la surface d'un substrat en silicium en raison d'un phénomène d'hydratation lié à l'humidité ambiante. Autrement dit, le perfluorodécyltrichlorosilane réagit, selon un mécanisme de substitution nucléophile, avec les groupes -OH présents à la surface du substrat en silicium.

Des compositions liquides pouvant être utilisées pour former la couche antiadhésive peuvent être des compositions commerciales fournies par la société 3M sous la référence NOVEC^{™} 2702, NOVEC^{™} 1700 ou NOVEC^{™} 1720 ou encore les compositions commerciales commercialisées par la société Daikin sous la référence Optool.

Avant l'étape de dépôt susmentionnée, le procédé de l'invention peut comprendre une étape de masquage de la zone centrale de la face supérieure du premier substrat, pour éviter que la couche antiadhésive ne se dépose également sur cette zone centrale. Il s'entend, dans le cas, qu'à l'issue de l'étape de dépôt, le procédé pourra comprendre, également, une étape de suppression du masque ainsi introduit.

Cette étape de masquage peut être réalisée :
- par photolithographie ; ou
- par dépôt, dans un premier temps, d'une couche adhésive sur toute la surface de la face supérieure du premier substrat suivi, dans un deuxième temps, de l'élimination, par exemple, par détourage, de la couche adhésive, sur la périphérie de la face supérieure.

En variante, l'étape de dépôt d'une couche périphérique antiadhésive peut comprendre les opérations suivantes :
- une opération de mise en contact du premier substrat, au niveau de sa face supérieure, avec une composition liquide comprenant un ou plusieurs composés antiadhésifs et au moins un solvant organique, la mise en contact pouvant se faire, par exemple, par enduction centrifuge ;
- une opération de séchage de ladite composition ainsi déposée par évaporation du ou desdites solvants ;
- une opération d'élimination de la couche ainsi obtenue au niveau de sa zone centrale pour ne laisser subsister qu'une couche périphérique.

L'opération d'élimination peut être obtenue par une abrasion mécanique (par exemple, au moyen d'une roue diamantée) de la zone centrale suivie éventuellement d'un polissage, par exemple, un polissage mécano-chimique pour gommer les éventuelles irrégularités de surface induites par l'abrasion mécanique.

Cette variante est particulièrement adaptée pour un premier substrat dont la zone centrale de la face supérieure est en protubérance par rapport à la périphérie de celle-ci, cette protubérance pouvant découler d'une opération préalable de détourage de la périphérie de la face supérieure.

Il s'entend que, selon cette variante, il n'est pas nécessaire de mettre en place une étape de masquage comme décrite ci-dessus.

Après l'étape de dépôt d'une couche antiadhésive sur la périphérie de la face supérieure du premier substrat et l'éventuelle étape de suppression du masque, le procédé de l'invention comprend une étape de dépôt sur la zone centrale de la face supérieure du premier substrat d'une couche adhésive en polymère(s) thermoplastique(s) et, plus particulièrement, en polymère(s) thermoplastique(s) adhésif(s). Par exemple, la couche peut être une couche en polyoléfine, tel que du polyéthylène, du polypropylène ; une couche en polyamide ; une couche en copolymère (éthylène-acétate de vinyle).

L'étape de dépôt sur la zone centrale peut comprendre, en particulier, les opérations suivantes :
- une opération de mise en contact de la face supérieure du premier substrat, avec une composition liquide comprenant une suspension de particules polymériques adhésives dans au moins un solvant organique, cette mise en contact se faisant par exemple, par centrifugation ;
- une opération de séchage de ladite composition ainsi déposée par évaporation du ou desdits solvants.

Du fait de la présence de la couche antiadhésive au niveau de la périphérie de la face supérieure du premier substrat, la couche adhésive en polymère(s) thermoplastique(s) se forme exclusivement sur la zone centrale de la face supérieure, qui ne comprend pas la couche antiadhésive.

Des compositions liquides pouvant être utilisées pour former la couche adhésive peuvent être des compositions commerciales BREWER^{™} 305 commercialisé par Brewer Science ou Zero Newton^{™} TWM12000 Series commercialisé par TOKYO OHKA KOGYO Co.

En parallèle, le procédé de l'invention comprend une étape de dépôt sur un deuxième substrat d'une couche antiadhésive, cette couche étant déposée sur la face supérieure du deuxième substrat à l'exclusion de sa périphérie, ladite périphérie étant ainsi dépourvue de ladite couche.

Cette couche antiadhésive peut être de même nature que la couche antiadhésive déposée sur le premier substrat.

Plus spécifiquement, la couche antiadhésive du deuxième substrat peut être, en particulier :
- une couche en un ou plusieurs polymères halogénés, tels qu'un polymère issu de la polymérisation d'au moins un monomère fluoré, par exemple, un monomère acrylate fluoré, un monomère éthylénique fluoré ;
- une couche en un ou plusieurs composés silanes et, plus particulièrement, une couche issue de la réaction d'un ou plusieurs composés halogénosilanes avec le premier substrat (notamment, lorsque celui-ci est un substrat en silicium), les composés halogénosilanes utilisables étant, par exemple, l'octadécyltrichlorosilane ou le perfluorodécyltrichlorosilane.

L'étape de dépôt de la couche antiadhésive peut comprendre, en particulier, les opérations suivantes :
- une opération de mise en contact du deuxième substrat, au niveau de la face supérieure à l'exclusion de la périphérie de celle-ci, avec une composition liquide comprenant un ou plusieurs composés antiadhésifs et au moins un solvant organique, la mise en contact pouvant se faire, par exemple, par enduction centrifuge ;
- une opération de séchage de ladite composition ainsi déposée par évaporation du ou desdites solvants.

Lors du séchage, si la composition comprend un ou plusieurs composés halogénosilanes et que le deuxième substrat est un substrat en silicium, le ou les composés halogénosilanes vont réagir avec les groupes hydroxyles présents spontanément à la surface du substrat en silicium pour former des greffons apportant le caractère antiadhésif au substrat, tel que des greffons répondant à la formule (I) mentionnée ci-dessus.

Lorsque le deuxième substrat est une plaque circulaire, il peut comporter, à l'issue de l'étape de dépôt, une zone circulaire centrale revêtue de la couche antiadhésive et une zone périphérique dénuée de ladite couche, cette zone périphérique formant une couronne, qui peut avoir un diamètre supérieur ou égal à 1 mm.

Comme pour l'étape de dépôt d'une couche périphérique antiadhésive pour le premier substrat, le procédé de l'invention peut comprendre une étape de masquage pouvant répondre aux mêmes modalités que celles définies ci-dessus, si ce n'est que le masque est apposé à la périphérie du deuxième substrat.

Le premier substrat et le deuxième substrat peuvent être constitués du même matériau et présenter des dimensions identiques et, en particulier, la face supérieure du premier substrat et la face supérieure du deuxième peuvent présenter la même forme et la même superficie.

En particulier, le premier substrat et le deuxième substrat peuvent être des plaques circulaires en silicium présentant un diamètre de 200 mm.

Le procédé comprend une étape de collage du premier substrat et du deuxième substrat consistant à thermocomprimer la face supérieure du premier substrat sur la face supérieure du deuxième substrat. Avantageusement, pour la thermocompression, la zone centrale du premier substrat revêtue d'une couche adhésive en polymère(s) thermoplastique(s) est mise en regard de la zone centrale du deuxième substrat revêtue d'une couche antiadhésive. Avantageusement, l'étape de collage par thermocompression est réalisée à une température et une pression efficaces pour permettre un étalement de la couche adhésive en polymère(s) thermoplastique(s), de sorte à permettre la jonction entre la couche périphérique du premier substrat et la zone périphérique du deuxième substrat. En particulier, la température appliquée est avantageusement supérieure à la température de transition vitreuse (dite Tg) du ou des polymères thermoplastiques constitutifs de la couche adhésive et, plus spécifiquement, peut être supérieure à (Tg + 100° C). Sous pression et à une telle température, le ou les polymères thermoplastiques peuvent devenir fluides et subir un fluage (notamment, lorsque la viscosité est inférieure à 10⁴ Pa.s) permettant ainsi de combler la lacune située entre la couche périphérique du premier substrat et la zone périphérique du deuxième substrat.

A l'issue de l'étape de collage par thermocompression, il subsiste un ensemble comprenant un empilement comprenant le premier substrat et le deuxième substrat entre lesquelles est interposée la couche adhésive en polymère(s) thermoplastique(s), ladite couche étant en contact direct avec le deuxième substrat *via* la périphérie dudit substrat et en contact indirect avec le deuxième substrat *via* la zone centrale de celui-ci, laquelle est occupée par une couche antiadhésive. La couche adhésive en polymère(s) thermoplastique(s) présente ainsi une adhérence plus importante au niveau de la périphérie du deuxième substrat par rapport à la périphérie du premier substrat, qui est recouverte d'une couche périphérique antiadhésive. Aussi, il en résulte une interface présentant une faible adhérence entre la couche adhésive en polymère(s) thermoplastique(s) et la périphérie de la face supérieure du premier substrat, ce qui permet une mise en oeuvre plus aisée de la dernière étape du procédé, à savoir, l'étape de retrait du premier substrat, moyennant quoi il subsistera le deuxième substrat dont la face supérieure est recouverte par la couche adhésive en polymère(s) thermoplastique(s).

Cette étape de retrait peut être effectuée par l'insertion d'un coin entre le premier substrat et le deuxième substrat, moyennant quoi l'interface présentant la plus faible adhérence s'ouvre. Comme mentionné ci-dessus, il s'agit de l'interface entre la couche adhésive en polymère(s) thermoplastique(s) et la périphérie de la face supérieure du premier substrat, cette insertion permettant ainsi un décollement de la couche adhésive en polymère(s) thermoplastique(s) du premier substrat, celle-ci restant en revanche sur la face supérieure du deuxième substrat.

Le deuxième substrat résultant de ce procédé présente, ainsi, sur sa face supérieure, une couche adhésive en polymère(s) thermoplastique(s) qui présente une adhérence au niveau de la périphérie de la face supérieure à l'adhérence au niveau de la zone centrale de la face supérieure, sachant que cette zone centrale est revêtue d'une couche antiadhésive. Ce deuxième substrat pourrait être ainsi utilisé dans le cadre d'un procédé de collage temporaire, tel que celui défini plus haut.

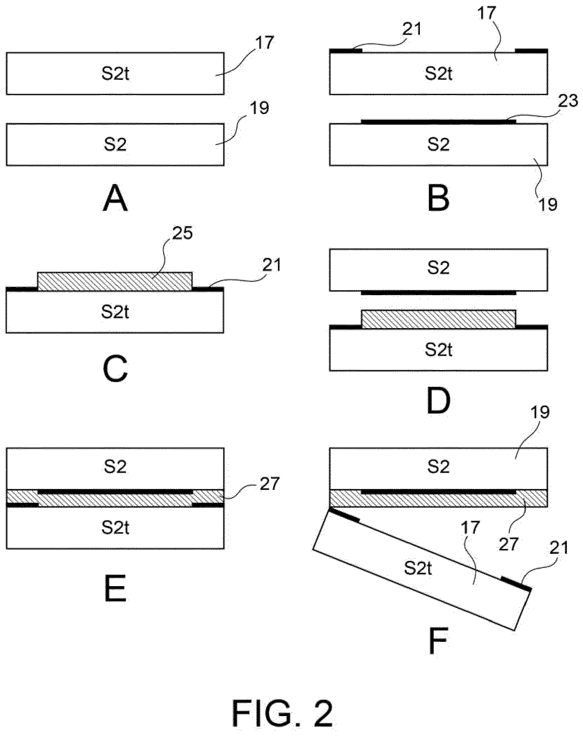

Un mode de réalisation particulier du procédé de l'invention est illustré sur la figure 2 jointe en annexe, qui comprend :
- sur la partie A, la fourniture du premier substrat 17, dit S2t et du deuxième substrat 19, dit S2 ;
- sur la partie B, le dépôt d'une couche périphérique antiadhésive 21 sur le premier substrat 17 et d'une couche antiadhésive 23 sur la zone centrale du deuxième substrat ;
- sur la partie C, le dépôt d'une couche adhésive 25 sur la zone centrale du premier substrat ;
- sur la partie D, la mise en regard de la face supérieure du premier substrat et de la face supérieure du deuxième substrat ;
- sur la partie E, la thermocompression du premier substrat et du deuxième substrat ;
- sur la partie F, le retrait du premier substrat 17, moyennant quoi il subsiste le deuxième substrat 19 dont la face supérieure est recouverte par la couche adhésive 27 issue de l'étalement de la couche adhésive 25.

Aussi, l'invention a également trait à un procédé de fabrication d'un substrat d'intérêt comprenant une face supérieure et une face inférieure, lesdites faces comprenant des composants électroniques, ledit procédé comprenant les étapes suivantes :
- une étape de mise en oeuvre du procédé de transfert tel que défini ci-dessus ;
- une étape de dépôt, sur la face supérieure d'un substrat d'intérêt déjà pourvue de composants électroniques, du deuxième substrat *via* sa couche adhésive en polymère(s) thermoplastique(s), lequel deuxième substrat est issu de l'étape de mise en oeuvre mentionnée ci-dessus ;
- une étape de réalisation de composants électroniques sur la face inférieure libre opposée à la face supérieure du substrat d'intérêt ;
- une étape de retrait du deuxième substrat de la face supérieure du substrat d'intérêt, laissant subsister la couche adhésive en polymère(s) thermoplastique(s) sur la face supérieure du substrat d'intérêt ;
- une étape d'élimination de la couche adhésive de la face supérieure, moyennant quoi il subsiste un substrat d'intérêt muni de composants électroniques tant sur sa face supérieure que sur sa face inférieure.

L'étape de retrait peut comprendre, en particulier, les opérations suivantes :
- une opération d'élimination de la périphérie de la couche adhésive en polymère(s) thermoplastique(s) ;
- une opération de décollement de la couche adhésive en polymère(s) thermoplastique(s) du deuxième substrat dans la partie centrale.

D'autres caractéristiques et avantages de l'invention apparaîtront mieux à la lecture du complément de description qui suit, qui se rapporte à des exemples conformes à l'invention.

Bien entendu, ces exemples ne sont donnés qu'à titre d'illustration de l'objet de l'invention et ne constituent en aucun cas une limitation de cet objet.

### BRÈVE DESCRIPTION DES DESSINS

La figure 1 illustre les différentes étapes d'un procédé classique de collage temporaire.
La figure 2 illustre les différentes étapes d'un mode particulier de réalisation de l'invention.

### EXPOSÉ DÉTAILLÉ DE MODES DE RÉALISATION PARTICULIERS

### EXEMPLE 1

Cet exemple illustre un mode particulier de mise en oeuvre du procédé de transfert de l'invention.

Il est procédé au masquage par photolithographie de la face supérieure d'une première plaque en silicium à l'exclusion de sa périphérie suivi du dépôt sur ladite périphérie d'une solution commerciale NOVEC^{™} 1720 comprenant un composé fluoré en solution dans un solvant méthyl nonafluorobutyl éther et du séchage de ladite solution commerciale ainsi déposée, moyennant quoi il subsiste une couche antiadhésive périphérique sur la face supérieure de la plaque en silicium se présentant sous forme d'une bande d'une largeur de 7 mm et présentant une énergie de surface de 11 mJ/m². Le masque est ensuite supprimé pour libérer la zone centrale de la face supérieure de ladite plaque.

En parallèle, il est procédé au dépôt sur toute la surface de la face supérieure d'une deuxième plaque en silicium de la même solution commerciale NOVEC^{™} 1720 et du séchage de ladite solution ainsi déposée, moyennant quoi il subsiste une couche antiadhésive sur toute la surface de la face supérieure de la deuxième plaque en silicium. Cette couche adhésive est ensuite éliminée uniquement de la périphérie de la face supérieure par détourage mécanique à la scie diamantée sur une profondeur de 2 µm et une largeur de 10 mm.

Sur la zone centrale de la face supérieure de la première plaque est déposée par enduction centrifuge une couche adhésive obtenue par dépôt d'un produit commercial BrewerBond^{®} 305 (comprenant des chaînes polymères dans du D-limonène) suivie d'un séchage à 200° C, ladite couche adhésive présentant une épaisseur de 40 µm.

Ensuite, la face supérieure du premier substrat et la face supérieure du deuxième substrat sont collées ensemble par thermocompression à une température de 250°C et une force de 15 kN, de telles conditions permettant à la couche adhésive présente initialement sur la face supérieure du premier substrat de fluer et de s'étaler pour assurer un contact entre la périphérie du premier substrat et la périphérie du deuxième substrat. L'adhérence de l'interface entre la couche adhésive et la périphérie du deuxième substrat (bordure non revêtue d'une couche antiadhésive) est de 2 J/m², tandis que l'adhérence entre la couche adhésive et la périphérie du premier substrat est de 0,2 J/m². Grâce à cette différence d'adhérence, le deuxième substrat est séparé du premier substrat par simple insertion d'un coin, en emportant la couche adhésive qui reste collée sur le deuxième substrat *via* sa périphérie.

### EXEMPLE 2

Cet exemple illustre un mode particulier de mise en oeuvre du procédé de transfert de l'invention.

Il est procédé au masquage par photolithographie de la face supérieure d'une première plaque en silicium à l'exclusion de sa périphérie suivi du dépôt sur ladite périphérie d'une solution commerciale NOVEC^{™} 1720 comprenant un composé fluoré en solution dans un solvant méthyl nonafluorobutyl éther et du séchage de ladite solution commerciale ainsi déposée, moyennant quoi il subsiste une couche antiadhésive sur la périphérie de la face supérieure de la plaque en silicium se présentant sous forme d'une bande d'une largeur de 2 mm et présentant une énergie de surface de 11 mJ/m². Le masque est ensuite supprimé pour libérer la zone centrale de la face supérieure de ladite plaque.

En parallèle, il est procédé au masquage par photolithographie de la périphérie de la face supérieure (selon une largeur de 2 mm) d'une deuxième plaque en silicium suivi du dépôt sur la zone centrale non masquée de la solution commerciale NOVEC^{™} 1720 et du séchage de ladite solution commerciale ainsi déposée.

Sur la zone centrale de la face supérieure de la première plaque est déposée par enduction centrifuge une couche adhésive obtenue par dépôt d'un produit commercial BrewerBond^{®} 305 (comprenant des particules polymères dans du D-limonène) suivie d'un séchage à 200° C, ladite couche adhésive présentant une épaisseur de 40 µm.

Ensuite, la face supérieure du premier substrat et la face supérieure du deuxième substrat sont collées ensemble par thermocompression à une température de 250°C et une force de 15 kN, de telles conditions permettant à la couche adhésive présente initialement sur la face supérieure du premier substrat de fluer et de s'étaler pour assurer un contact entre la couche périphérique du premier substrat et la périphérie du deuxième substrat. L'adhérence de l'interface entre la couche adhésive et la périphérie du deuxième substrat (bordure non revêtue d'une couche antiadhésive) est de 2 J/m², tandis que l'adhérence entre la couche adhésive et la périphérie du premier substrat est de 0,2 J/m². Grâce à cette différence d'adhérence, le deuxième substrat est séparé du premier substrat par simple insertion d'un coin, en emportant la couche adhésive qui reste collée sur le deuxième substrat *via* sa périphérie.

### EXEMPLE 3

Cet exemple illustre un mode particulier de mise en oeuvre du procédé de transfert de l'invention.

Il est procédé à un laminage sur la face supérieure d'une première plaque en silicium d'une feuille adhésive du type Lintec Adwill^{®} D610 suivi d'un détourage de la feuille ainsi laminée à la périphérie de la face supérieure sur une largeur de 1 mm au moyen d'une scie diamantée automatique, moyennant il subsiste une zone périphérique de laquelle la feuille adhésive a été supprimée.

L'ensemble est ensuite immergé dans une solution commerciale NOVEC^{™} 2702 puis séché par centrifugation. La feuille adhésive, qui subsiste sur la zone centrale de la face supérieure, est insolée par application d'un rayonnement UV puis est décollée de son substrat. La face supérieure de la première plaque comporte ainsi une couche périphérique antiadhésive, laquelle présente une énergie de surface de 5 mJ/m².

En parallèle, il est procédé au masquage par photolithographie de la périphérie de la face supérieure (selon une largeur de 1 mm) d'une deuxième plaque en silicium suivi du dépôt sur la zone centrale non masquée d'une solution commerciale NOVEC^{™} 2702 et du séchage de ladite solution commerciale ainsi déposée.

Sur la zone centrale de la face supérieure de la première plaque est déposée par enduction centrifuge une couche adhésive obtenue par dépôt d'un produit commercial BrewerBond^{®} 305 (comprenant des chaînes polymères dans du D-limonène) suivie d'un séchage à 200 °C, ladite couche adhésive présentant une épaisseur de 40 µm.

Ensuite, la face supérieure du premier substrat et la face supérieure du deuxième substrat sont collées ensemble par thermocompression à une température de 250°C et une force de 15 kN, de telles conditions permettant à la couche adhésive présente initialement sur la face supérieure du premier substrat de fluer et de s'étaler pour assurer un contact entre la couche périphérique du premier substrat et la périphérie du deuxième substrat. L'adhérence de l'interface entre la couche adhésive et la périphérie du deuxième substrat (bordure non revêtue d'une couche antiadhésive) est de 2 J/m², tandis que l'adhérence entre la couche adhésive et la périphérie du premier substrat est de 0,2 J/m². Grâce à cette différence d'adhérence, le deuxième substrat est séparé du premier substrat par simple insertion d'un coin, en emportant la couche adhésive qui reste collée sur le deuxième substrat *via* sa périphérie.

### EXEMPLE 4

Cet exemple illustre un mode particulier de mise en oeuvre du procédé de transfert de l'invention.

Il est procédé au masquage par photolithographie de la face supérieure d'une première plaque en silicium à l'exclusion de sa périphérie suivi du dépôt sur ladite périphérie d'une solution comprenant du perfluorodécyltrichlorosilane et de l'isooctane et du séchage de ladite solution ainsi déposée, moyennant quoi il subsiste une couche antiadhésive à la périphérie de la face supérieure de la plaque en silicium se présentant sous forme d'une bande d'une largeur de 5 mm et présentant une énergie de surface de 10 mJ/m². Le masque est ensuite supprimé pour libérer la zone centrale de la face supérieure de ladite plaque.

En parallèle, il est procédé au dépôt sur toute la surface de la face supérieure d'une deuxième plaque en silicium d'une solution de perfluorodécyltrichlorosilane dans l'isooctane et du séchage de ladite solution ainsi déposée, moyennant quoi il subsiste une couche antiadhésive sur toute la surface de la face supérieure de la deuxième plaque en silicium. Cette couche adhésive est ensuite éliminée uniquement de la périphérie de la face supérieure par détourage à la scie diamantée sur une profondeur de 10 µm et une largeur de 3 mm, la couche adhésive subsistante sur la zone centrale de la face supérieure de la deuxième plaque présentant une énergie de surface de 10 mJ/m².

Sur la zone centrale de la face supérieure de la première plaque est déposée par enduction centrifuge une couche adhésive obtenue par dépôt d'un produit commercial Zéro Newton^{™} TWM12000 Series obtenu auprès du fournisseur TOK (Tokyo Ohka Kogyo Product) suivie d'un séchage à 220°C, ladite couche adhésive présentant une épaisseur de 100 µm.

Ensuite, la face supérieure du premier substrat et la face supérieure du deuxième substrat sont collées ensemble par thermocompression à une température de 240°C et une force de 20 kN, de telles conditions permettant à la couche adhésive présente initialement sur la face supérieure du premier substrat de fluer et de s'étaler pour assurer un contact entre la couche périphérique du premier substrat et la périphérie du deuxième substrat. L'adhérence de l'interface entre la couche adhésive et la périphérie du deuxième substrat (bordure non revêtue d'une couche antiadhésive) est de 3 J/m², tandis que l'adhérence entre la couche adhésive et la périphérie du premier substrat est de 0,9 J/m². Grâce à cette différence d'adhérence, le deuxième substrat est séparé du premier substrat par simple insertion d'un coin, en emportant la couche adhésive qui reste collée sur le deuxième substrat *via* sa périphérie.

### EXEMPLE 5

Cet exemple illustre un mode particulier de mise en oeuvre du procédé de transfert de l'invention.

Au moyen d'une scie diamantée, une première plaque de silicium est détourée, sur la périphérie de sa face supérieure, sur une largeur de 2 mm et une profondeur de 15 µm, moyennant quoi il subsiste une première plaque en silicium dont la zone centrale de la face supérieure est en protubérance par rapport à sa périphérie. La première plaque de silicium ainsi détourée est ensuite immergée dans une solution d'octadécyltrichlorosilane dans l'isooctane puis séché par centrifugation, moyennant quoi une couche antiadhésive recouvre toute la face supérieure tant sur sa zone centrale en protubérance que sur sa périphérie. La couche antiadhésive présente une énergie de surface de 17 mJ/m². Au moyen d'une roue diamantée, la zone centrale est soumise à une abrasion mécanique de sorte à éliminer 10 µm d'épaisseur et, par ailleurs, la couche antiadhésive à la surface de la zone centrale. Ladite zone centrale est ensuite soumise à un polissage mécano-chimique de sorte à gommer les irrégularités induites par l'abrasion mécanique. A l'issue de ce polissage est déposée, par enduction centrifuge, sur la zone centrale de la face supérieure de la première plaque, une couche adhésive obtenue par dépôt du produit commercial BrewerBond^{®} 305 (comprenant des particules polymères dans du D-limonène) suivie d'un séchage à 200° C, ladite couche adhésive présentant une épaisseur de 50 µm.

En parallèle, il est procédé au masquage par photolithographie de la périphérie de la face supérieure (selon une largeur de 1 mm) d'une deuxième plaque en silicium suivi du dépôt sur la zone centrale non masquée d'une solution d'octadécyltrichlorosilane dans l'isooctane et du séchage de ladite solution ainsi déposée. Après suppression du masque, il résulte une plaque en silicium, dont la face supérieure est revêtue sur sa zone centrale d'une couche antiadhésive et la périphérie est dénuée de ladite couche selon une bande extérieure de 2 mm.

Ensuite, la face supérieure du premier substrat et la face supérieure du deuxième substrat sont collées ensemble par thermocompression à une température de 250°C et une force de 15 kN, de telles conditions permettant à la couche adhésive présente initialement sur la face supérieure du premier substrat de fluer et de s'étaler pour assurer un contact entre la couche périphérique du premier substrat et la périphérie du deuxième substrat. L'adhérence de l'interface entre la couche adhésive et la périphérie du deuxième substrat (bordure non revêtue d'une couche antiadhésive) est de 2 J/m², tandis que l'adhérence entre la couche adhésive et la périphérie du premier substrat est de 0,1 J/m². Grâce à cette différence d'adhérence, le deuxième substrat est séparé du premier substrat par simple insertion d'un coin, en emportant la couche adhésive qui reste collée sur le deuxième substrat *via* sa périphérie.

## Revendications

1. Procédé de transfert d'une couche adhésive en polymère(s) thermoplastique(s) d'un premier substrat (17) vers un deuxième substrat (19) comprenant les étapes suivantes :
- une étape de dépôt sur un premier substrat (17) d'une couche antiadhésive, cette couche étant déposée sur la périphérie de la face supérieure dudit substrat, dite couche périphérique (21), ménageant ainsi sur ladite face supérieure une zone dépourvue de ladite couche, dite zone centrale ;
- une étape de dépôt sur ladite zone centrale d'une couche adhésive (25) en polymère(s) thermoplastique(s) ;
- une étape de dépôt sur un deuxième substrat (19) d'une couche antiadhésive (23), cette couche étant déposée sur la face supérieure du deuxième substrat à l'exclusion de sa périphérie, ladite périphérie étant ainsi dépourvue de ladite couche antiadhésive ;
- une étape de collage du premier substrat (17) et du deuxième substrat (19) consistant à thermocomprimer la face supérieure du premier substrat (17) sur la face supérieure du deuxième substrat (19) ;
- une étape de retrait du premier substrat (17), moyennant quoi il subsiste le deuxième substrat (19) dont la face supérieure est recouverte par la couche adhésive en polymère(s) thermoplastique(s).

2. Procédé selon la revendication 1, dans lequel le premier substrat (17) et/ou le deuxième substrat (19) est (sont) en un matériau semi-conducteur.

3. Procédé selon la revendication 1 ou 2, dans lequel le premier substrat (17) et/ou le deuxième substrat (19) est (sont) en silicium, en germanium ou en alliage silicium-germanium, de préférence en silicium.

4. Procédé selon l'une quelconque des revendications précédentes, dans lequel la couche périphérique antiadhésive (21) présente une énergie de surface inférieure à 20 J/m².

5. Procédé selon l'une quelconque des revendications précédentes, dans lequel, lorsque le premier substrat (17) est une plaque circulaire en silicium, la couche périphérique antiadhésive (21) se présente sous forme d'une couronne, de préférence sous forme d'une couronne présentant une largeur supérieure ou égale à 1 mm.

6. Procédé selon l'une quelconque des revendications précédentes, dans lequel la couche périphérique antiadhésive (21) est :
- une couche en un ou plusieurs polymères halogénés; ou
- une couche en un ou plusieurs composés silanes greffés sur le premier substrat.

7. Procédé selon l'une quelconque des revendications précédentes, dans lequel, lorsque la couche périphérique antiadhésive est en un ou plusieurs composés silanes greffés sur le premier substrat, celle-ci est issue de la réaction d'un ou plusieurs composés halogénosilanes avec le premier substrat.

8. Procédé selon la revendication 7, dans lequel, lorsque le premier substrat (17) est un substrat en silicium et le composé halogénosilane utilisé est du perfluorodécyltrichlorosilane, la couche périphérique antiadhésive (21) correspond à une couche comprenant des greffons issus de la réaction du perfluorodécyltrichlorosilane avec le substrat en silicium, lesdits greffons répondant à la formule suivante :

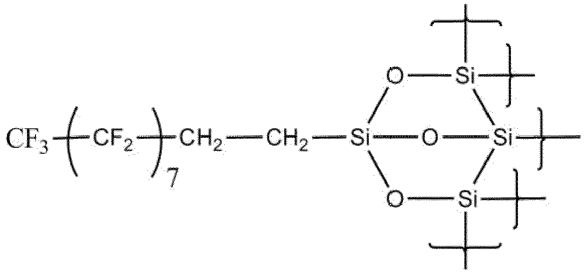

9. Procédé selon l'une quelconque des revendications précédentes, dans lequel l'étape de dépôt de la couche périphérique antiadhésive (21) comprend :
- une opération de mise en contact du premier substrat, au niveau de la périphérie de sa face supérieure, avec une composition liquide comprenant un ou plusieurs composés antiadhésifs et au moins un solvant organique ;
- une opération de séchage de ladite composition ainsi déposée par évaporation du ou desdites solvants.

10. Procédé selon l'une quelconque des revendications précédentes, comprenant, en outre, avant l'étape de dépôt de la couche périphérique antiadhésive, une étape de masquage de la zone centrale de la face supérieure du premier substrat (17).

11. Procédé selon la revendication 10, dans lequel l'étape de masquage est réalisée :
- par photolithographie ; ou
- par dépôt, dans un premier temps, d'une couche adhésive sur toute la surface de la face supérieure du premier substrat suivi, dans un deuxième temps, de l'élimination de la couche adhésive, sur la périphérie de la face supérieure.

12. Procédé selon l'une quelconque des revendications précédentes, dans lequel l'étape de dépôt sur la zone centrale comprend les opérations suivantes :
- une opération de mise en contact de la face supérieure du premier substrat (17), avec une composition liquide comprenant une suspension de particules polymériques adhésives dans au moins un solvant organique ;
- une opération de séchage de ladite composition ainsi déposée par évaporation du ou desdits solvants.

13. Procédé selon l'une quelconque des revendications précédentes, dans lequel le premier substrat (17) et le deuxième substrat (19) sont constitués du même matériau et présentent des dimensions identiques.

14. Procédé selon l'une quelconque des revendications précédentes, dans lequel l'étape de retrait est effectuée par l'insertion d'un coin entre le premier substrat (17) et le deuxième substrat (19).

15. Procédé de fabrication d'un substrat d'intérêt comprenant une face supérieure et une face inférieure, lesdites faces comprenant des composants électroniques, ledit procédé comprenant les étapes suivantes :
- une étape de mise en oeuvre du procédé tel que défini selon l'une quelconque des revendications 1 à 14 ;
- une étape de dépôt, sur la face supérieure d'un substrat d'intérêt déjà pourvue de composants électroniques, du deuxième substrat (19) *via* sa couche adhésive en polymère(s) thermoplastique(s), lequel deuxième substrat est issu de l'étape de mise en oeuvre mentionnée ci-dessus ;
- une étape de réalisation de composants électroniques sur la face inférieure libre opposée à la face supérieure du substrat d'intérêt ;
- une étape de retrait du deuxième substrat (19) de la face supérieure du substrat d'intérêt, laissant subsister la couche adhésive en polymère(s) thermoplastique(s) sur la face supérieure du substrat d'intérêt ;
- une étape d'élimination de la couche adhésive de la face supérieure, moyennant quoi il subsiste un substrat d'intérêt muni de composants électroniques tant sur sa face supérieure que sur sa face inférieure.
